# EUROPÄISCHE PATENTSCHRIFT

(11) **EP 0 902 986 B1**
(45) Veröffentlichungstag und Bekanntmachung des Hinweises auf die Patenterteilung: **14.08.2002**
(21) Anmeldenummer: 97924885.3
(22) Anmeldetag: 14.05.1997
(51) Int. Cl.: H01L 41/09, H01L 41/047

(54) **PIEZOELEKTRISCHES ELEMENT SOWIE VERFAHREN ZU DESSEN HERSTELLUNG**
PIEZOELECTRIC ELEMENT AND PROCESS FOR ITS PRODUCTION
ELEMENT PIEZO-ELECTRIQUE ET SON PROCEDE DE FABRICATION

(30) Priorität: 23.05.1996 DE 19620826
(43) Veröffentlichungstag der Anmeldung: 24.03.1999
(73) Patentinhaber: SIEMENS AKTIENGESELLSCHAFT, 80333 München (DE)
(72) Erfinder: RIEDEL, Michael, D-96489 Niederfüllbach (DE); SESTAK, Hans-Jürgen, 96215 Lichtenfels (DE)
(86) Internationale Anmeldenummer: DE9700974
(87) Internationale Veröffentlichungsnummer: WO9744834

(56) Entgegenhaltungen:
- EP-A- 0 709 195
- WO-A-96/41384
- US-A- 3 872 332

## Beschreibung

Die Erfindung bezieht sich auf einen piezoelektrischen Biegewandler mit einem elektrisch isolierenden Tragkörper, auf welchem ein Piezoelektret aufgetragen ist, sowie auf ein Verfahren zur Herstellung eines solchen piezoelektrischen Biegewandlers. Die Erfindung nimmt dabei Bezug auf das Problem, für einen piezoelektrischen Biegewandler mit einem isolierenden Tragkörper eine sichere elektrische Kontaktierung, insbesondere bei hoher mechanischer Belastung, zu gewährleisten.

Ein Biegewandler der eingangs genannten Art, im folgenden piezoelektrisches Element genannt, dient vorrangig zur Ausnutzung des indirekten oder reziproken piezoelektrischen Effekts, d.h. der Umwandlung von elektrischer in mechanische Energie. Gleichwohl eignet sich ein derartiges piezoelektrisches Element aber auch dazu, mechanische in elektrische Energie umzuwandeln. Hierbei wird der direkte piezoelektrische Effekt ausgenutzt.

Für ein piezoelektrisches Element, wie es vorstehend beschrieben ist, gibt es eine Vielzahl von technischen Anwendungen. Solche Anwendungen sind z.B. als piezoelektrischer Druckkopf für einen Tintenstrahldrucker, als Schallaufnehmer oder -erzeuger für Mikrofone bzw. Lautsprecher, als Sensor für die Beschleunigungs- oder Druckmessung, als Stellelement in Braille-Zeilen in Lesegeräten für Blinde, in Textilmaschinen, in Pneumatikventilen, in schreibenden Meßgeräten oder in berührungslosen Oberflächen-Meßinstrumenten usw.

Gemäß der EP-0 455 342 B1 und der EP-0 468 796 A1 wird ein derartiges piezoelektrisches Element in einer Schichtstruktur aufgebaut. Ein piezoelektrisch aktives Material, welches den piezoelektrischen und/oder den elektrostriktiven Effekt zeigt und im folgenden als Piezoelektret bezeichnet werden soll, wird dabei zur Verbesserung der mechanischen Stabilität des Elements oder zum Zwecke einer besseren Umsetzung von elektrischer in mechanische Energie oder umgekehrt auf einen Träger oder Tragkörper aufgebracht. Für die elektrische Kontaktierung wird der Piezoelektret beidseitig mit Elektroden in Form einer flächigen Belegung aus einem leitfähigen Material versehen.

Je nach Anwendung kann der Tragkörper ein- oder zweiseitig mit der beschriebenen Schichtabfolge versehen sein. Nach der DE-34 34 726 C2 können auch mehrere Lagen von Piezoelektreten einschließlich der Elektroden übereinander gestapelt sein. Je nach Anzahl der piezoelektrisch aktiven Schichten spricht man von einem mono-, bi-, tri- etc. oder allgemein multimorphen piezoelektrischen Element.

Piezoelektrische Elemente mit jeweils einem nichtleitenden bzw. elektrisch isolierenden Tragkörper finden sich in der DE-43 37 265 C1 und der DE-40 25 436 A1. Durch die Verwendung eines isolierenden Tragkörpers lassen sich bei einem bimorphen piezoelektrischen Element die dem Tragkörper zugewandten Seiten der Piezoelektreten bzw. die sich darauf befindlichen inneren Elektroden auf unterschiedliches Potential legen. Dadurch kann die Ansteuerung eines derartigen piezoelektrischen Elements ausschließlich über die innenliegenden, durch den Tragkörper gegeneinander isolierten Seiten der Piezoelektreten bzw. die inneren Elektroden erfolgen, während die außenliegenden Seiten bzw. die äußeren Elektroden auf Nullpotential oder Masse gelegt sind. Durch diese Maßnahme wird ein derartiges piezoelektrisches Element berührungssicher. Nichtleitende Materialien können sich aber ebenso gut aufgrund anderer spezifischer Eigenschaften als der Eigenschaften der elektrischen Isolierung für den Tragkörper eignen, beispielsweise aufgrund eines an den Piezoelektreten angepaßten thermischen Ausdehnungskoeffizienten zur Vermeidung von Temperaturspannungen.

Ein piezoelektrisches Element mit einem elektrisch isolierenden Tragkörper ist auch in der nachveröffentlichten WO 96/41384 A1 (DE 195 20 796 A1) gezeigt. Dort weist der Tragkörper eine Metallisierungsschicht auf, die um den Rand des Tragkörpers auf die andere Seite geführt ist, um die inneren Elektroden der beidseitig auf den Tragkörper aufgebrachten Piezokeramiken auf dasselbe elektrische Potential zu ziehen.

Ein nichtleitender Tragkörper führt jedoch naturgemäß zu einer Kontaktierungsschwierigkeit an der dem Träger zugewandten Seite oder Innenseite des Piezoelektreten. Aus der DE-40 25 436 A1 ist hierzu bekannt, die Innenseite des Piezoelektreten mit einer inneren Elektrode in Form einer Metallisierung zu versehen, die Metallisierung über den Rand des Piezoelektreten hinauszuführen und dort mit Hilfe eines Lötkontakts zu kontaktieren.

Jedoch wird bei einem piezoelektrischen Element mit einem Tragkörper aus einem elektrisch isolierenden Material die Kontaktierung der Innenseite des Piezoelektreten ausschließlich über das Material einer inneren Elektrode gewährleistet. Durch einen Bruch der inneren Elektrode wird demzufolge ein Teil des piezoelektrischen Elements von der Spannungsversorgung für die innere Elektrode abgetrennt. Das piezoelektrische Element ist nicht mehr funktionsfähig. Da die innere Elektrode bruchempfindlich ist, kann die Lebensdauer eines piezoelektrischen Elements mit isolierendem Tragkörper nicht mit der Lebensdauer eines piezoelektrischen Elements mit leitfähigem Tragkörper konkurrieren.

Aufgabe der Erfindung ist es, ein piezoelektrisches Element mit einem Tragkörper aus einem elektrisch isolierenden Material anzugeben, welches auch bei einer Materialermüdung einer inneren Elektrode voll funktionsfähig bleibt. Ferner ist es Aufgabe der Erfindung, ein Verfahren zur Herstellung eines derartigen piezoelektrischen Elements anzugeben.

Die Aufgabe hinsichtlich eines piezoelektrischen Elements mit einem Tragkörper aus einem elektrisch isolierenden Material wird erfindungsgemäß dadurch gelöst, daß der Tragkörper mit einer elektrisch leitfähigen Belegung versehen ist, welche mit einer inneren Elektrode eines auf den Tragkörper aufgebrachten Piezoelektreten an einer Anzahl von Stellen in elektrischem Kontakt steht, und daß der Tragkörper aus einem duroplastischen Material besteht.

Die Erfindung geht dabei von der Erkenntnis aus, daß es bei einem piezoelektrischen Element mit einem Tragkörper während des Betriebs infolge einer Materialermüdung z.B. durch fortwährende mechanische Belastung, zu einem Bruch oder Riß einer sich zwischen dem Tragkörper und dem Piezoelektreten befindlichen inneren Elektrode kommt. Eine derartige Materialermüdung der inneren Elektrode tritt häufig auf, da Druck- oder Temperaturspannungen an der Grenzfläche zwischen dem Piezoelektreten und dem Tragkörper das Material der inneren Elektrode zusätzlich belasten. Besteht der Tragkörper aus einem elektrisch leitfähigen Material, so führt ein derartiger Bruch nicht zu einem Funktionsausfall des piezoelektrischen Elements, da die Kontaktierung weiterhin über den Tragkörper gewährleistet ist. Dafür ist es lediglich erforderlich, daß der Tragkörper an genügend vielen Stellen einen elektrischen Kontakt mit der inneren Elektrode aufweist. Eine derartige Materialermüdung der inneren Elektrode wird daher bei einem leitfähigen Tragkörper gar nicht bemerkt.

Wird jedoch für ein piezoelektrisches Element mit einem Tragkörper aus elektrisch isolierendem Material zwischen dem Tragkörper und der inneren Elektrode des Piezoelektreten eine elektrisch leitfähige Belegung eingelegt, welche mit der inneren Elektrode an einer Anzahl von Stellen in elektrischem Kontakt steht, so wird durch diese Belegung zusätzlich die Kontaktierung der inneren Elektrode gewährleistet. Das piezoelektrische Element bleibt bei einer Materialermüdung der inneren Elektrode funktionsfähig. Dies gilt insbesondere selbst dann, wenn durch eine hohe mechanische Belastung auch die leitfähige Belegung brechen oder reißen sollte, da es unwahrscheinlich ist, daß ein Bruch der inneren Elektrode und ein Bruch der leitfähigen Belegung an gleicher Stelle auftreten.

Die Verwendung eines duroplastischen Materials ermöglicht ein einfaches Herstellungsverfahren.

Die externe Kontaktierung der inneren Elektrode und der leitfähigen Belegung erfolgt vorteilhafterweise über eine Metallfolie, welche sich zum Anbringen eines Lötkontaktes eignet. Besonders vorteilhaft hierzu sind Kupferfolien, die leicht kontaktiert werden können und die in verschiedenen Stärken am Markt erhältlich sind. Zur Kontaktierung kann ein Teil der Metallfolie einfach zwischen den Piezoelektreten und den Tragkörper eingelegt werden. Der Lötkontakt für den Anschluß an eine externe Spannungsquelle wird auf dem überstehenden, freien Teil der Metallfolie angebracht. Dabei ist es für die Funktionsfähigkeit des piezoelektrischen Elements unwichtig, ob die Metallfolie zwischen den Piezoelektreten und die leitfähige Belegung, zwischen die leitfähige Belegung und die innere Elektrode oder zwischen die innere Elektrode und den Piezoelektreten eingelegt ist. Die günstigste Ausgestaltung hängt dabei von dem Herstellungsprozeß des piezoelektrischen Elements ab.

Das Einlegen einer Metallfolie führt jedoch zu einer Verbiegung der die Folie umgebenden Schichten, wodurch bei mechanischer Belastung durch zusätzliche Druck- bzw. Zugspannungen eine Sollbruchstelle definiert ist, die zu einem Funktionsausfall führen kann. Eine solche Sollbruchstelle läßt sich vermeiden, wenn an der Stelle des eingelegten Teils der Metallfolie die leitfähige Belegung weggelassen wird. In diesem Fall geschieht die Kontaktierung der leitfähigen Belegung mit der Metallfolie über die innere Elektrode. Um hier einen Funktionsausfall des piezoelektrische Elements durch einen Riß der inneren Elektrode zwischen leitfähiger Belegung und eingelegter Metallfolie zu vermeiden, kann das eingelegte Ende der Metallfolie beispielsweise V-förmig ausgebildet sein; ebenso das sich dem eingelegten Teil der Metallfolie anschließende Ende der leitfähigen Belegung. Dadurch ist die Kontaktierung bei einem quer verlaufenden Riß der inneren Elektrode weiterhin gewährleistet.

Die erwähnte Sollbruchstelle kann aber auch durch Wahl einer genügend dünnen eingelegten Metallfolie vermieden werden. Für übliche piezoelektrische Elemente eignen sich Metallfolien mit einer Dicke von weniger als 10 µm.

Am vorteilhaftesten ist es, wenn der Tragkörper länger als der Piezoelektret ist und sich die leitfähige Belegung auf den freien Teil des Tragkörpers erstreckt und dort mit der Metallfolie kontaktiert ist. Die Kontaktierung kann dabei beispielsweise dadurch realisiert werden, daß die sich auf dem freien Teil des Tragkörpers erstreckende leitfähige Belegung einfach mit der Metallfolie in Form eines Plättchens überklebt und der Lötkontakt auf das Plättchen gesetzt wird. Bei geeignetem Material der leitfähigen Belegung kann der Lötkontakt auch direkt auf die überstehende leitfähige Belegung gesetzt werden.

Vorteilhafterweise ist die leitfähige Belegung als eine duktile, d.h. flexible und verformbare Folie ausgebildet. Die Verformbarkeit kann dabei durch ein geeignetes Material, wie z.B. einen flexiblen Kunststoff, oder durch eine geringe Dicke der Folie erreicht werden. So eignet sich als duktile Folie z.B eine Metallfolie mit einer Dicke von weniger als 100 µm. Durch die Duktilität ist ausgeschlossen, daß die leitfähige Belegung bei mechanischer Belastung, z.B. einer Verbiegung, reißt. Die Folie kann durch Verkleben, Verschmelzen oder durch sonstige Verbindungstechniken auf den Tragkörper oder auf die innere Elektrode des Piezoelektreten aufgebracht werden. Der Tragkörper wird dann mit dem Piezoelektreten zu dem piezoelektrischen Element verklebt, verschweißt oder sonstwie verbunden. Die elektrische Kontaktierung der Folie mit der inneren Elektrode kann über einen leitfähigen Kleber geschehen, oder es wird ein nichtleitender Kleber derart dünn aufgebracht, daß durch mikroskopische Rauhigkeiten der Folie und der inneren Elektrode durch den Kleber hindurch noch ein direkter Kontakt zwischen der Folie und der inneren Elektrode besteht.

Die Verbindung des Piezoelektreten mit dem Tragkörper über die leitfähige Belegung läßt sich wesentlich vereinfachen, wenn als leitfähige Belegung ein Netzwerk verwendet wird. Unter einem Netzwerk soll hier ein im wesentlichen zweidimensionaler Körper verstanden werden, welcher Öffnungen aufweist. Ein solcher Körper ist beispielsweise ein Gewebe oder eine perforierte Folie. Die innere Elektrode kann dann über die Öffnungen in dem Netzwerk direkt mit dem Tragkörper verklebt oder anders verbunden werden. Das Netzwerk kann vor dem Verbinden lose aufgelegt werden. Auch durch ein Netzwerk ist an genügend vielen Stellen eine Kontaktierung mit der inneren Elektrode gegeben. Des weiteren lassen sich durch Materialeinsparung die Herstellungskosten senken.

Wird das piezoelektrische Element als Bewegungs- oder Verstellelement verwendet, so tritt eine mechanische Belastung häufig durch wiederholte Auslenkung des Elements in eine vorgegebene Richtung auf. Ein Bruch der inneren Elektrode entsteht dann mit einer hohen Wahrscheinlichkeit senkrecht zu dieser Auslenkungsrichtung. Für ein solches Element kann das Netzwerk vorteilhafterweise in Form von parallelen Stegen ausgebildet sein. Die Streifen sind dabei vorzugsweise senkrecht zu der Auslenkungsrichtung des piezoelektrischen Elements anzuordnen. Insbesondere kann in Einzelfällen ein einziger Steg oder Streifen genügen, um die Funktionsfähigkeit des piezoelektrischen Elements bei einem Bruch der inneren Elektrode zu gewährleisten. Ein Steg kann beispielsweise durch Kleben, durch Verschweißen oder Verschmelzen auf den Tragkörper aufgebracht werden. Es ist aber auch vorstellbar, einen Steg vor dem Verbinden des Tragkörpers mit dem Piezoelektreten zu dem piezoelektrischen Element lose aufzulegen. Sowohl ein Netzwerk als auch zueinander parallele Stege können auch mit Hilfe eines Druckverfahrens, z.B. mit Hilfe eines Siebdruckverfahrens, in Form einer Paste oder Flüssigkeit aufgetragen werden.

Als Material für die leitfähige Belegung eignet sich prinzipiell ein Metall oder ein elektrisch leitfähiger Kunststoff. Als Kunststoff ist dabei besonders ein Carbon-Polymer oder ein mit Metallfasern verstärktes Epoxidharz von Vorteil. Unter einem Carbon-Polymer wird hierbei ein hitzehärtendes Harz mit Graphit als Pigment verstanden. Das Carbon-Polymer läßt sich vor der Aushärtung beispielsweise in Form einer Paste durch das Siebdruckverfahren auftragen. Mit Metallfasern oder mit einem Metallgewebe verstärktes Epoxidharz eignet sich besonders in Form eines sogenannten Prepregs (noch nicht ausgehärteter, weicher, mit Epoxidharz vorimprägnierter Rohling). Der Tragkörper kann dann über die leitfähige Belegung mit der inneren Elektrode des Piezoelektreten dauerhaft dadurch verbunden werden, daß die leitfähige Belegung in Form eines Prepregs lose zwischen den Tragkörper und der inneren Elektrode eingelegt wird und anschließend Tragkörper und Piezoelektret durch Druck verpreßt und bei einer Wärmebehandlung unter Aushärtung des Prepregs verklebt werden.

Die innere Elektrode des Piezoelektreten ist vorteilhafterweise als eine Metallisierung ausgebildet. Die Metallisierung kann durch Sputtern, Verdampfen eines Metalls oder im Siebdruckverfahren auf die Oberfläche des Piezoelektreten aufgetragen werden. Eine Metallisierung in Form einer dünnen, metallischen Oberflächenbeschichtung ist besonders für die Erzeugung eines homogenen elektrischen Feldes im Piezoelektreten und damit für eine optimale Energieumsetzung geeignet. Durch den direkten Kontakt mit dem Piezoelektreten und durch die geeignete Dicke ist eine Metallisierungsschicht jedoch besonders bruch- oder rißgefährdet.

Zweckmäßigerweise weist der Piezoelektret auf der dem Tragkörper abgewandten Seite eine äußere Elektrode auf. Diese kann wie die innere Elektrode als Metallisierung ausgebildet sein. Zur Vermeidung von Funktionsausfällen kann auch die äußere Elektrode mit einer leitfähigen, duktilen Schicht belegt sein. Hierfür eignet sich besonders ein Carbon-Polymer, welches eine hohe Haftfestigkeit bei gleichzeitig hoher Flexibilität aufweist. Auch ist vorstellbar, die äußere Elektrode selbst als eine leitfähige, duktile Belegung des Piezoelektreten auszubilden.

Ein piezoelektrisches Element mit einem Tragkörper aus einem nichtleitenden Material zeigt eine hohe Berührungssicherheit. Die Ansteuerung durch Anlegen einer Spannung kann allein über die innere Elektrode erfolgen, während eine äußere Elektrode auf Nullpotential liegt. Vorzugsweise ist die spannungsführende innere Elektrode nach außen vollständig isoliert, indem der Tragkörper aus elektrisch isolierendem Material die leitfähige Belegung und die innere Elektrode an Randbereichen, d.h. an den freiliegenden Seitenflächen, übergreift. Alternativ vorzugsweise können freiliegende, spannungsführende Teile der leitfähigen Belegung und der inneren Elektrode mit einem elektrisch isolierenden Lack versehen werden.

Eine besonders gute Umsetzung von elektrischer in mechanische Energie ist möglich, wenn der Tragkörper die Form eines flachen Plättchens hat und beidseitig mit der leitfähigen Belegung und dem Piezoelektreten versehen ist. Ein derartiges piezoelektrisches Element eignet sich insbesondere für die Verwendung als Biegewandler oder Aktor. Derartige Biegewandler werden in der Textilindustrie zur Ansteuerung von Web-, Wirk- oder Strickmaschinen, insbesondere für die Erzeugung von Mustern mit Hilfe der Jacquard-Technik, eingesetzt. Des weiteren wird ein solcher Aktor für Blinden-Lesegeräte zur Betätigung einzelner Tastelemente, in Pneumatik-Ventilen oder Video-/Audiogeräten verwendet.

Für den Piezoelektreten sind prinzipiell alle Materialien geeignet, welche den piezoelektrischen bzw. elektrostriktiven Effekt zeigen. Besonders vorteilhaft sind bestimmte Oxidkeramiken, z.B. Blei-Zirkonat-Titan, die über ihre Zusammensetzung eine Anpassung an unterschiedliche Anforderungen erlauben. Damit eine solche Keramik oder Piezokeramik den piezoelektrischen Effekt zeigt, ist eine Polarisation derselben in einem homogenen elektrischen Feld erforderlich. Auf diese Weise wird eine polare Achse in der Piezokeramik erzeugt, die für das Auftreten des piezoelektrischen Effekts notwendig ist. Besonders einfach kann diese Polarisation erfolgen, wenn die für das piezoelektrische Element vorgesehene Piezokeramik beidseitig Elektroden in Form einer Metallisierung besitzt. Das gewünschte, homogene elektrische Feld wird dabei durch Anlegen einer genügend hohen elektrischen Spannung erzeugt.

Die Polarisation der Piezokeramik kann entweder vor oder nach dem Verbinden mit dem Tragkörper geschehen. Dafür ist in der Regel ein elektrisches Feld von einigen kV/mm notwendig. Da jedwede Druck- oder Zugspannung innerhalb der Piezokeramik zu einer Depolarisation und damit zu einer Abschwächung des pie zoelektrischen Effekts führt, sollten die thermischen Ausdehnungskoeffizienten des Tragkörpers und der Piezokeramik aneinander angepaßt sein. Dies ist dann der Fall, wenn der Tragkörper anstelle aus einem kohlefaserverstärkten Epoxidharz aus einem glasfaserverstärkten Epoxidharz und die Piezokeramik aus der genannten Blei-Zirkonat-Titan-Keramik besteht.

Bezüglich des Herstellungsverfahrens für ein piezoelektrisches Element mit einem Tragkörper aus einem elektrisch isolierenden Material wird die Aufgabe erfindungsgemäß dadurch gelöst, daß eine leitfähige Belegung auf ein Prepreg eines Duroplasten als Tragkörper aufgebracht und das Prepreg unter Einschluß der leitfähigen Belegung mit Hilfe einer Wärmebehandlung mit einem Piezoelektreten verbunden wird, wobei an einer Anzahl von Stellen ein elektrischer Kontakt der leitfähigen Belegung mit einer inneren Elektrode des Piezoelektreten entsteht.

Es ist weder ein Klebemittel für die Verbindung der leitfähigen Belegung mit dem Tragkörper noch für die Verbindung der leitfähigen Belegung mit der inneren Elektrode notwendig.

Die leitfähige Belegung wird zunächst in Form eines Netzwerks lose auf das Prepreg, vorteilhafterweise ein Prepreg eines glasfaserverstärkten Epoxidharzes, oder auf die innere Elektrode aufgelegt bzw. durch Druckverfahren aufgebracht. Zur Verbindung werden anschließend Tragkörper, leitfähige Belegung und Piezoelektret locker in eine entsprechende Form gelegt. Durch leichtes Pressen umfließt das Prepreg das Netzwerk, welches durch das lockere Auflegen direkt mit der inneren Elektrode in Verbindung steht, und verklebt den Tragkörper durch das Netzwerk hindurch mit der inneren Elektrode des Piezoelektreten. Alternativ ist auch vorstellbar, für die leitfähige Belegung selbst ein Prepreg, z.B. ein Kupfergewebe-Prepreg, zu verwenden. Durch Anwendung einer abschließenden Wärmebehandlung härtet das Prepreg unter Bildung des Duroplasten irreversibel aus und man erhält dadurch eine dauerhafte und stabile Verbindung des piezoelektrischen Elements.

Im folgenden werden Ausführungsbeispiele der Erfindung anhand einer Zeichnung näher erläutert. Darin zeigen:
- FIG 1: in perspektivischer Darstellung ein piezoelektrisches Element mit einer leitfähigen Belegung eines Tragkörpers in Form einer Folie.
- FIG 2: in perspektivischer Darstellung ein piezoelektrisches Element mit einer leitfähigen Belegung eines Tragkörpers in Form eines Flechtwerks.
- FIG 3: in perspektivischer Darstellung ein piezoelektrisches Element mit einer leitfähigen Belegung eines Tragkörpers in Form einer Anzahl von parallelen Stegen.
- FIG 4: in perspektivischer Darstellung ein piezoelektrisches Element mit einer leitfähigen Belegung eines Tragkörpers in Form einer Anzahl von in den Tragkörper eingelegten parallelen Stegen.
- FIG 5: in perspektivischer Darstellung ein piezoelektrisches Element mit einer doppelseitigen Beschichtung eines Tragkörpers.
- FIG 6: einen Schnitt durch ein piezoelektrisches Element mit einer Kontaktierung über eine aufgelegte Metallfolie.
- FIG 7: einen Schnitt durch ein piezoelektrisches Element mit einer Kontaktierung über eine teilweise eingelegte Metallfolie.
- FIG 8: ein piezoelektrisches Element, welches als ein Biegewandler für die Nadelsteuerung einer Strick-, Web-oder Wirkmaschine ausgebildet ist, mit einer leitfähigen Belegung eines Tragkörpers in Form eines Netzwerks.
- FIG 9: ein piezoelektrisches Element, welches als ein Biegewandler für die Nadelsteuerung einer Strick-, Web-oder Wirkmaschine ausgebildet ist, mit einer leitfähigen Belegung eines Tragkörpers in Form einer Anzahl von parallelen Stegen.

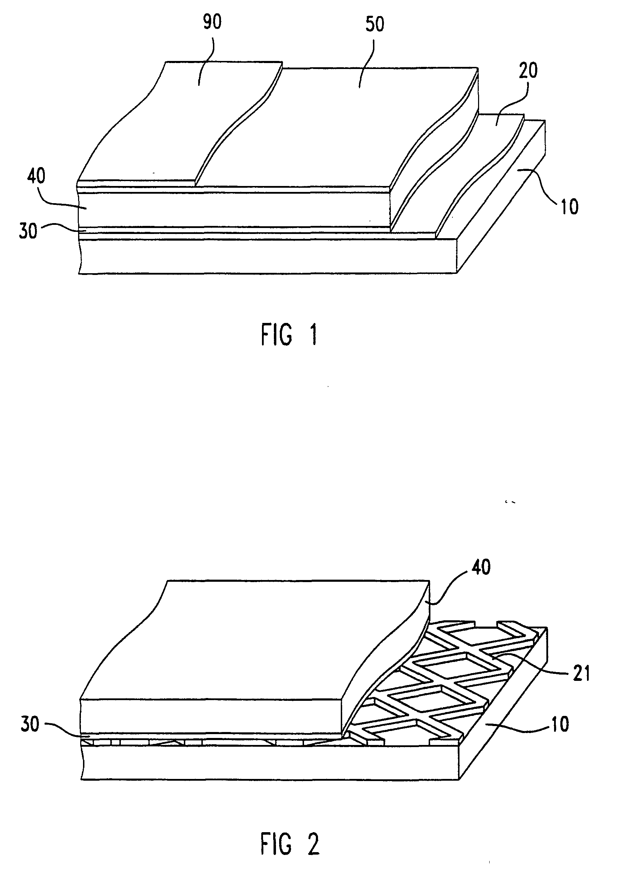

FIG 1 zeigt in einer perspektivischen Darstellung den Schichtaufbau eines piezoelektrischen Elements mit einem Tragkörper 10 aus einem elektrisch isolierenden Material. Auf den Tragkörper 10 ist eine elektrisch leitfähige Belegung aufgebracht, die hier in Form einer flächig den Tragkörper 10 bedeckenden Folie 20 ausgebildet ist. Auf der leitfähigen Folie 20 ist ein Piezoelektret 40 angeordnet, welcher mit einer inneren Elektrode 30 und einer äußeren Elektrode 50 versehen ist. Die beiden Elektroden 30 und 50 sind jeweils in Form einer dünnen Metallisierungsschicht auf den Piezoelektreten 40 aufgetragen. Die leitfähige Folie 20 kann mit dem Tragkörper 10 sowie mit der inneren Elektrode 30 verklebt oder verschmolzen sein, wobei jedoch ein elektrischer Kontakt zwischen der inneren Elektrode 30 und der leitfähigen Folie 20 vorhanden ist. Das Anlegen einer elektrischen Spannung an die beiden Elektroden 30 und 50 führt zu einer Stauchung bzw. Dehnung des Piezoelektreten 40. Wird als Piezoelektret 40 eine Piezokeramik verwendet, so führt das Anlegen einer solchen Spannung zu einer Verbiegung des piezoelektrischen Elements, da Piezokeramiken einen transversalen piezoelektrischen Effekt zeigen. Eine Stauchung bzw. Dehnung erfolgt senkrecht zur Richtung des angelegten elektrischen Feldes.

Eine hohe mechanische Belastung des piezoelektrischen Elements durch eine Verbiegung führt leicht zu Rissen des Piezoelektreten 40 quer zur Verbiegungsrichtung. Ein solcher Riß kann zu einem Aufplatzen der inneren Elektrode 30 und damit zu einem Funktionsausfall des piezoelektrischen Elements führen. Die zusätzlich eingelegte leitfähige Folie 20 des elektrisch isolierenden Tragkörpers 10 führt in einem solchen Fall zu einem Erhalt der Funktionsfähigkeit, da der Kontakt der inneren Elektrode 30 immer noch durch die leitfähige Folie 20 hergestellt wird. Ein Bruch der äußeren Elektrode 50 ist im allgemeinen selten zu beobachten, da hier nicht die durch das Verkleben des Piezoelektreten 40 mit dem Tragkörper 10 verursachten Druck- bzw. Zugspannungen auftreten. Dies gilt nicht für einen Biegewandler. Hier kann insbesondere auch die äußere Elektrode 50 durch starke Belastung reißen oder brechen. Der Funktionsausfall des piezoelektrischen Elements aufgrund eines solchen Bruches der äußeren Elektrode 50 läßt sich auch durch Auflegen einer leitfähigen Belegung 90 auf die äußere Elektrode 50 vermeiden.

Die leitfähige Belegung des Tragkörpers 10 ist in FIG 2 als ein Netzwerk 21 ausgebildet. Auf diese Weise läßt sich Material einsparen und trotzdem die volle Funktionsfähigkeit des piezoelektrischen Elements bei Bruch der inneren Elektrode 30 aufrechterhalten. Als Flechtwerk eignet sich beispielsweise ein kommerziell verfügbares Kupfer-Gewebe. In FIG 2 besitzt der Piezoelektret 40 keine äußere Elektrode 50. Die dem Tragkörper 10 abgewandte Seite des Piezoelektreten 40 wird erst beim Einbau in ein entsprechendes Gerät mit einem auf Erdpotential liegenden Teil kontaktiert. Zum Ansteuern wird dann die innere Elektrode 30 bzw. die leitfähige Belegung, hier in Form eines Netzwerks 21 auf ein entsprechendes Potential gegenüber Masse (d.h. Erdpotential) gelegt.

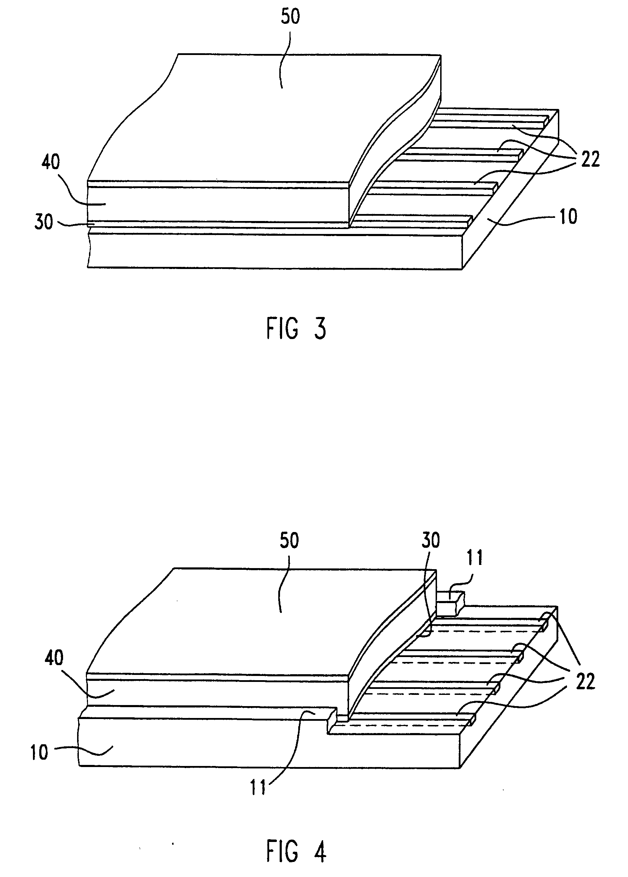

Eine weitere Ausgestaltung der leitfähigen Belegung findet sich in FIG 3. Die leitfähige Belegung ist hier auf eine Anzahl parallel verlaufender Stege 22 reduziert. Vorzugsweise liegen diese Stege senkrecht zu einer zu erwartenden Verbiegung des piezoelektrischen Elements. In diesem Fall liegen die Stege 22 quer zu den zu erwartenden Rissen der inneren Elektrode 30. Die Funktionsfähigkeit des in FIG 3 gezeichneten Elements bleibt demnach erhalten bei einer Verbiegung senkrecht zu den einzelnen Schichten. Diese Bewegungsrichtung ist durch Pfeile symbolisiert.

Das technisch sehr aufwendige Verkleben der leitfähigen Belegung sowohl mit dem Tragkörper 10 als auch der inneren Elektrode 30 entfällt, wenn als Material für den Tragkörper 10 ein Prepreg verwendet wird. In FIG 4 ist der Schichtaufbau eines piezoelektrischen Elements mit einem Tragkörper aus einem duroplastischen Material gezeichnet. Die leitfähige Belegung ist dabei in Form von parallelen Stegen 22 in den Tragkörper 10 eingelassen. Der Tragkörper 10 besteht beispielsweise aus einem glasfaserverstärkten Epoxidharz. Das Material für die leitfähigen Stege 22 ist ein Carbon-Polymer. Im Herstellungsverfahren wird für den Tragkörper 10 ein sogenanntes Prepreg, d.h. ein noch nicht vollständig ausgehärteter glasfaserverstärkter Kunststoff, verwendet. Als leitfähige Belegung wird ein Carbon-Polymer mit Hilfe des Siebdruckverfahrens in Form einer Anzahl von parallelen Stegen 22 auf das Prepreg aufgetragen. Anschließend wird der Piezoelektret 40 mit der inneren Elektrode 30 und der äußeren Elektrode 50 auf den mit den Stegen 22 versehenen Tragkörper 10 aufgelegt und in eine Form eingebracht. Durch eine Druckanwendung umfließt zunächst der noch nicht völlig ausgehärtete Kunststoff die aufgebrachten leitfähigen Stege 22 und verklebt mit der inneren Elektrode 30. Gleichzeitig bleibt jedoch der elektrische Kontakt zwischen den leitfähigen Stegen 22 und der inneren Elektrode 30 bestehen. Durch Anwenden einer Wärmebehandlung wird das Prepreg ausgehärtet, wodurch eine dauerhafte Verbindung des Tragkörpers mit der inneren Elektrode entsteht.

Der Tragkörper 10 in FIG 4 übergreift im Randbereich die innere Elektrode 30 und die leitfähigen Stege 22. Der dafür ausgebildete Steg 11 dient der Berührsicherheit des piezoelektrischen Elements.

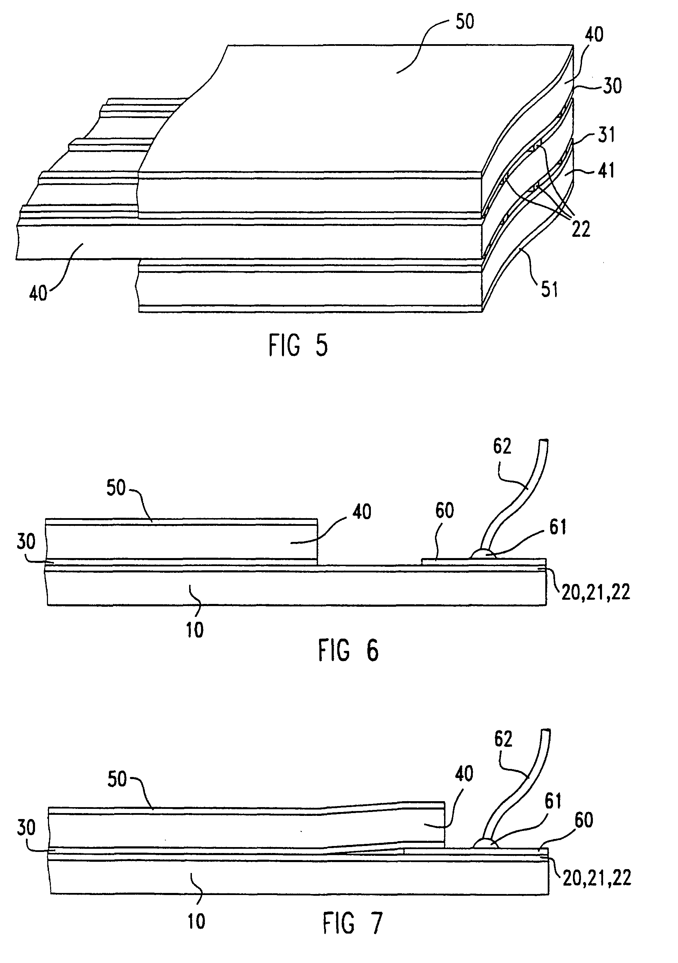

In FIG 5 ist ein piezoelektrisches Element mit einem Tragkörper 40 aus einem elektrisch isolierenden Material dargestellt, wobei der Tragkörper 40 eine beidseitige Beschichtung aufweist. Auf beiden Seiten des Tragkörpers 40 ist eine leitfähige Belegung in Form von Stegen 22, eine innere Elektrode 30 bzw. 31, ein Piezoelektret 40 bzw. 41 sowie eine äußere Elektrode 50 bzw. 51 in der angegebenen Reihenfolge angeordnet. Ein solcher, sogenannter dimorpher Aufbau ist besonders geeignet bei der Verwendung von Piezokeramiken als Piezoelektret 40, 41. Piezokeramiken dürfen keinem elektrischen Feld ausgesetzt werden, welches ihrer Polarisationsrichtung entgegensteht. Ein derartiges elektrisches Feld würde zu einer Depolarisation und damit zu einem Verlust des piezoelektrischen Effekts führen.

Zum Ansteuern des in FIG 5 dargestellten piezoelektrischen Elements werden die beiden äußeren Elektroden 50, 51 auf Erdpotential gelegt. Die beiden inneren Elektroden 30 und 31 werden abwechselnd auf 0 und 200 Volt gelegt, wobei 200 V eine für eine Piezokeramik übliche Betriebsspannung darstellt. Ist die innere Elektrode 31 auf 0 Volt, liegt die innere Elektrode 30 auf +200 Volt und umgekehrt. Zeigt die Polarisationsrichtung beider Piezokeramiken 40, 41 von dem Tragkörper 10 weg (d.h. in Richtung des angelegten Feldes!), so läßt sich der Vorteil einer Berührungssicherheit mit einer einfachen Beschaltung kombinieren, mit welcher eine Auslenkung des piezoelektrischen Elements in zwei entgegengesetzte Raumrichtungen möglich ist. Dabei ist jeweils nur einer der Piezoelektreten 41 und 40 einem elektrischen Feld ausgesetzt, also aktiv.

Die Berührungssicherheit des in FIG 5 dargestellten piezoelektrischen Elements wird gewährleistet, indem die offenen, unter Spannung stehenden Randbereiche mit einem elektrisch isolierenden Lack versehen werden. Ebenso ist es möglich, wie bereits in FIG 4 dargestellt, den Tragkörper derart auszugestalten, daß er die beidseitig aufgebrachte leitfähige Belegung, hier in Form der Stege 22, und die beiden inneren Elektroden 30, 31 übergreift.

Zur Kontaktierung des piezoelektrischen Elements mit einem Tragkörper aus einem elektrisch isolierenden Material ist gemäß FIG 6 vorgesehen, den Tragkörper 10 zusammen mit der leitfähigen Belegung 20, 21, 22 nur teilweise mit dem Piezoelektreten 40 zu versehen. Auf dem freien Teil des Tragkörpers 10 ist eine Metallfolie 60 auf die leitfähige Belegung 20, 22, 22 aufgeklebt. An dieser Metallfolie 60 ist ein Anschlußkabel 62 über einen Lötkontakt 61 befestigt.

Eine alternative Ausgestaltungsmöglichkeit der Kontaktierung zeigt FIG 7. Hier ist eine Metallfolie 60 zwischen die innere Elektrode 30 und die leitfähige Belegung 20, 21, 22 eingelegt. Zur besseren Kontaktierung und zur besseren Befestigung der Metallfolie 60 sind auch hier der Tragkörper 10 und die leitfähige Belegung 20, 21, 22 nicht ganz von dem Piezoelektreten 40 bedeckt. Auf dem freien Teil der Metallfolie 60 ist wiederum über einen Lötkontakt 61 ein Anschlußkabel 62 befestigt. Infolge der Verbiegung der sich in unmittelbarer Nähe der eingelegten Metallfolie 60 befindlichen Schichten kann sich eine Sollbruchstelle ergeben. Jedoch ist das Herstellungsverfahren technisch einfacher als für das in FIG 6 dargestellte Element. Zur Vermeidung der Sollbruchstelle kann die leitfähige Belegung 20, 21, 22 an der Stelle der Metallfolie 60 fehlen.

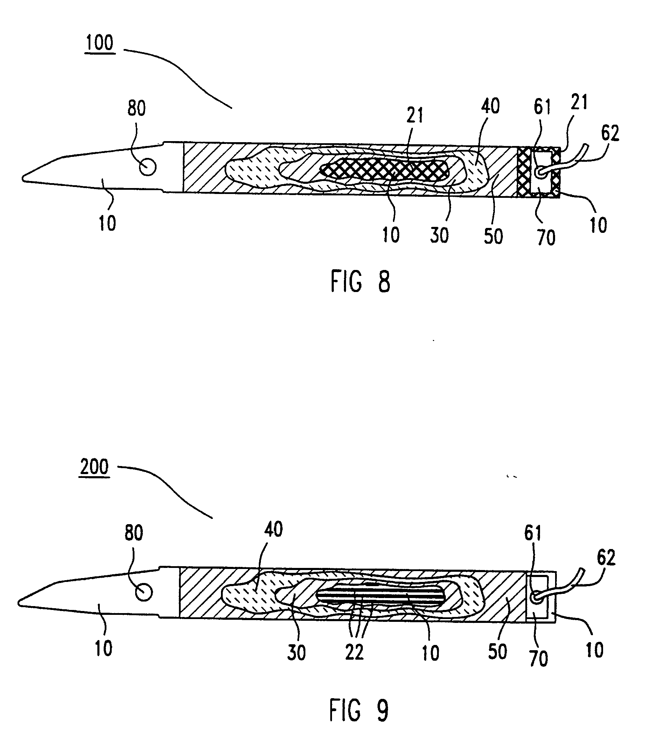

Figuren 8 und 9 zeigen jeweils ein piezoelektrisches Element, welches als ein Biegewandler 100, 200 für die Nadelsteuerung in einer Web-, Strick- oder Wirkmaschine mit einem erfindungsgemäßen piezoelektrischen Element ausgestaltet ist. Der Tragkörper 10 aus einem elektrisch isolierenden Material läuft in einer abgerundeten Form aus, welche eine Bohrung 80 aufweist. Diese Ausgestaltung dient der Aufnahme einer Legenadel für eine Web- oder Wirkmaschine. Die Kontaktierung des Biegewandlers 100 bzw. 200 erfolgt auf dem entgegengesetzten Ende über ein Anschlußkabel 62, einen Lötkontakt 61 sowie eine Kupferfolie 70 mit einer Dicke von 9 µm. Beide Biegewandler 100 und 200 weisen beidseitig die hier dargestellte Beschichtung auf. Lediglich der Einfachheit halber ist nur eine Seite jedes Biegewandlers dargestellt.

Der in FIG 8 dargestellte Biegewandler 100 weist einen Tragkörper 10 mit einer leitfähigen Belegung in Form eines Netzwerks 21 auf. Als Netzwerk 21 ist ein Kupfer-Gewebe mit einer Dicke von 50 µm vorgesehen. Der Tragkörper 10 sowie das Kupfer-Gewebe sind mit einer Piezokeramik 40, welche eine innere Elektrode 30 und einer äußere Elektrode 50 aufweist, wie dargestellt teilweise beschichtet. Auf dem der Bohrung 80 entgegengesetzten Ende des Biegewandlers 100 ist das Kupfer-Gewebe des leitfähigen Netzwerks 21 frei zugänglich. Dort ist über das Kupfer-Gewebe eine dünne Kupfer-Folie 70 zur Kontaktierung mit dem Anschlußdraht 62 über einen Lötkontakt 61 geklebt. Auf die äußere Elektrode 50 ist - hier nicht dargestellt - eine Carbon-Polymer Dickfilmpaste aufgetragen, welche den Vorteil der Abriebfestigkeit aufweist. Sämtliche Seitenteile des Biegewandlers 100 sind mit einem elektrisch isolierenden Lack versehen.

Der in FIG 9 dargestellte Biegewandler 200 zeigt denselben Schichtaufbau wie der Biegewandler 100 in FIG 8. Lediglich die leitfähige Belegung ist hier in Form einer Anzahl von parallelen Stegen 22 ausgebildet. Des weiteren ist zur Kontaktierung des Biegewandlers 200 eine Kupferfolie 70 mit einer bereits erwähnten Dicke von 9 µm, wie in FIG 7 dargestellt, zwischen die innere Elektrode 30 und die leitfähige Belegung eingelegt. Die leitfähigen Stege 21 bestehen aus einem Carbon-Polymer und weisen eine Dicke von etwa 10 µm auf. Die Stege 22 sollten nicht zu dick sein, da sonst dadurch Sollbruchstellen erzeugt werden.

Der Tragkörper beider Biegewandler 100 und 200 besteht aus einem glasfaserverstärkten Epoxidharz. Bei der Herstellung wird dieses Epoxidharz in Form eines Prepregs verwendet, so daß der Tragkörper 10 unter Umfließen der leitfähigen Belegung direkt mit der inneren Elektrode 30 des Piezoelektreten 40 verklebt wird, wie dies in FIG 4 dargestellt ist.

## Patentansprüche

1. Piezoelektrischer Biegewandler mit einem Tragkörper (10) aus einem elektrisch isolierenden Material und einem darauf aufgebrachten Piezoelektreten (40, 41) mit einer inneren, dem Tragkörper (10) zugewandten Elektrode (30, 31),
**dadurch gekennzeichnet, daß** die innere Elektrode (30, 31) des Piezoelektreten (40, 41) über eine zusätzliche elektrisch leitfähige Belegung (z.B. 20), welche mit der inneren Elektrode (30, 31) an einer Anzahl von Stellen in elektrischem Kontakt steht, mit dem Tragkörper (10) verbunden ist, wobei die leitfähige Belegung (z.B. 20) nicht auf die dem Piezoelektreten abgewandte Seite des Tragkörpers (10) geführt ist, und daß der Tragkörper (10) aus einem duroplastischen Material besteht.

2. Piezoelektrischer Biegewandler nach Anspruch 1,
**dadurch gekennzeichnet, daß** die externe Kontaktierung der inneren Elektrode (30, 31) über eine Metallfolie (60), vorzugsweise über eine Kupferfolie (70), erfolgt, welche sich zum Anbringen eines Lötkontaktes (61) eignet.

3. Piezoelektrischer Biegewandler nach Anspruch 2,
**dadurch gekennzeichnet, daß** ein Teil der Metallfolie (60) zwischen den Piezoelektreten (40, 41) und den Tragkörper (10) eingelegt ist.

4. Piezoelektrischer Biegewandler nach Anspruch 2,
**dadurch gekennzeichnet, daß** der Tragkörper (10) länger als der Piezoelektret (40, 41) ist und sich die leitfähige Belegung auf einen freien Teil des Tragkörpers (10) erstreckt und dort mit der Metallfolie (60) kontaktiert ist.

5. Piezoelektrischer Biegewandler nach einem der vorhergehenden Ansprüche,
**dadurch gekennzeichnet, daß** die leitfähige Belegung eine duktile Folie (20) ist.

6. Piezoelektrischer Biegewandler nach einem der vorhergehenden Ansprüche,
**dadurch gekennzeichnet, daß** die leitfähige Belegung ein Netzwerk (21) ist.

7. Piezoelektrischer Biegewandler nach Anspruch 6,
**dadurch gekennzeichnet, daß** das Netzwerk (21) in Form von parallelen Stegen (22) ausgebildet ist.

8. Piezoelektrischer Biegewandler nach einem der vorhergehenden Ansprüche,
**dadurch gekennzeichnet, daß** die leitfähige Belegung aus einem Metall besteht.

9. Piezoelektrischer Biegewandler nach einem der vorhergehenden Ansprüche,
**dadurch gekennzeichnet, daß** die leitfähige Belegung aus einem elektrisch leitenden Kunststoff besteht.

10. Piezoelektrischer Biegewandler nach Anspruch 9,
**dadurch gekennzeichnet, daß** der Kunststoff ein Carbon-Polymer ist.

11. Piezoelektrischer Biegewandler nach Anspruch 9,
**dadurch gekennzeichnet, daß** der Kunststoff ein mit Metallfaser verstärktes Epoxidharz ist.

12. Piezoelektrischer Biegewandler nach einem der vorhergehenden Ansprüche,
**dadurch gekennzeichnet, daß** die innere Elektrode (30, 31) eine Metallisierungsschicht ist.

13. Piezoelektrischer Biegewandler nach einem der vorhergehenden Ansprüche,
**dadurch gekennzeichnet, daß** der Piezoelektret (40, 41) eine äußere Elektrode (50, 51) auf der dem Tragkörper abgewandten Seite aufweist.

14. Piezoelektrischer Biegewandler nach Anspruch 13,
**dadurch gekennzeichnet, daß** die äußere Elektrode (50, 51) mit einer leitfähigen, duktilen Schicht belegt ist.

15. Piezoelektrischer Biegewandler nach einem der vorhergehenden Ansprüche,
**dadurch gekennzeichnet, daß** der Tragkörper (10) die leitfähige Belegung und die innere Elektrode (30, 31) an Randbereichen übergreift.

16. Piezoelektrischer Biegewandler nach einem der vorhergehenden Ansprüche,
**dadurch gekennzeichnet, daß** freiliegende Teile der leitfähigen Belegung und der inneren Elektrode (30, 31) mit einem elektrisch isolierenden Lack versehen sind.

17. Piezoelektrischer Biegewandler nach einem der vorhergehenden Ansprüche,
**dadurch gekennzeichnet, daß** der Tragkörper (10) die Form eines flachen Plättchens hat und beidseitig jeweils mit einer leitfähigen Belegung und einem Piezoelektreten (40, 41) versehen ist.

18. Piezoelektrischer Biegewandler nach einem der vorhergehenden Ansprüche,
**dadurch gekennzeichnet, daß** der Piezoelektret (40, 41) eine Piezokeramik ist.

19. Verfahren zum Herstellen eines piezoelektrischen Biegewandlers mit einem Tragkörper (10) aus einem elektrisch isolierenden Material,
**dadurch gekennzeichnet , daß** eine leitfähige Belegung auf ein Prepreg eines Duroplasten als Tragkörper (10) aufgebracht und das Prepreg unter Einschluß der leitfähigen Belegung mit Hilfe einer Wärmebehandlung mit einem Piezoelektreten (40, 41) verbunden wird, wobei an einer Anzahl von Stellen ein elektrischer Kontakt der leitfähigen Belegung mit einer inneren Elektrode (30, 31) des Piezoelektreten (40, 41) entsteht.

20. Verfahren nach Anspruch 19,
**dadurch gekennzeichnet , daß** die leitfähige Belegung in Form eines Netzwerks (21) auf den Tragkörper (10) aufgebracht wird.

21. Verfahren nach Anspruch 19,
**dadurch gekennzeichnet, daß** die leitfähige Belegung in Form eines Metallgewebe-Prepregs, vorzugsweise in Form eines Kupfergewebe-Prepregs, auf den Tragkörper (10) aufgebracht und das Metallgewebe-Prepreg mit Hilfe einer Wärmebehandlung mit dem Piezoelektreten (40, 41) verbunden wird.

## Claims

1. Piezoelectric bending transducer with a supporting body (10) made of an electrically insulating material and a piezoelectret (40, 41) applied to the latter, with an internal electrode (30, 31) facing the supporting body (10), **characterized in that** the internal electrode (30, 31) of the piezoelectret (40, 41) is connected to the supporting body (10) via an additional electrically conductive covering (e.g. 20), which is in electrical contact with the internal electrode (30, 31) at a number of points, the conductive covering (e.g. 20) not being led onto the side of the supporting body (10) facing away from the piezoelectret, and **in that** the supporting body (10) consists of a thermosetting material.

2. Piezoelectric bending transducer according to Claim 1, **characterized in that** the external electrical bonding of the internal electrode (30, 31) takes place via a metal foil (60), preferably via a copper foil (70), which is suitable for providing a solder contact (61).

3. Piezoelectric bending transducer according to Claim 2, **characterized in that** part of the metal foil (60) is placed between the piezoelectret (40, 41) and the supporting body (10).

4. Piezoelectric bending transducer according to Claim 2, **characterized in that** the supporting body (10) is longer than the piezoelectret (40, 41) and the conductive covering extends onto a free part of the supporting body (10) and is electrically bonded there to the metal foil (60).

5. Piezoelectric bending transducer according to one of the preceding claims, **characterized in that** the conductive covering is a ductile foil (20).

6. Piezoelectric bending transducer according to one of the preceding claims, **characterized in that** the conductive covering is a network (21).

7. Piezoelectric bending transducer according to Claim 6, **characterized in that** the network (21) takes the form of parallel webs (22).

8. Piezoelectric bending transducer according to one of the preceding claims, **characterized in that** the conductive covering consists of a metal.

9. Piezoelectric bending transducer according to one of the preceding claims, **characterized in that** the conductive covering consists of an electrically conducting plastic.

10. Piezoelectric bending transducer according to Claim 9, **characterized in that** the plastic is a carbon polymer.

11. Piezoelectric bending transducer according to Claim 9, **characterized in that** the plastic is an epoxy resin reinforced with metal fibre.

12. Piezoelectric bending transducer according to one of the preceding claims, **characterized in that** the internal electrode (30, 31) is a metallization layer.

13. Piezoelectric bending transducer according to one of the preceding claims, **characterized in that** the piezoelectret (40, 41) has an external electrode (50, 51) on the side facing away from the supporting body.

14. Piezoelectric bending transducer according to Claim 13, **characterized in that** the external electrode (50, 51) is coated with a conductive, ductile layer.

15. Piezoelectric bending transducer according to one of the preceding claims, **characterized in that** the supporting body (10) reaches over the conductive covering and the internal electrode (30, 31) at marginal regions.

16. Piezoelectric bending transducer according to one of the preceding claims, **characterized in that** exposed parts of the conductive covering and of the internal electrode (30, 31) are provided with an electrically insulating coating.

17. Piezoelectric bending transducer according to one of the preceding claims, **characterized in that** the supporting body (10) has the form of a flat platelet and is provided on each of both sides with a conductive covering and a piezoelectret (40, 41).

18. Piezoelectric bending transducer according to one of the preceding claims, **characterized in that** the piezoelectret (40, 41) is a piezoceramic.

19. Process for producing a piezoelectric bending transducer with a supporting body (10) from an electrically insulating material, **characterized in that** a conductive covering is applied to a prepreg of a thermosetting material as a supporting body (10) and the prepreg is connected to a piezoelectret (40, 41) with inclusion of the conductive covering by means of a heat treatment, an electrical contact of the conductive covering with an internal electrode (30, 31) of the piezoelectret (40, 41) being produced at a number of points.

20. Process according to Claim 19, **characterized in that** the conductive covering is applied to the supporting body (10) in the form of a network (21).

21. Process according to Claim 19, **characterized in that** the conductive covering is applied to the supporting body (10) in the form of a metal-mesh prepreg, preferably in the form of a copper-mesh prepreg, and the metal-mesh prepreg is connected to the piezoelectret (40, 41) by means of a heat treatment.

## Revendications

1. Transducteur piézo-électrique de flexion comprenant un support (10) en un matériau isolant de l'électricité et un électret (40, 41) piézo-électrique qui y est déposé et qui comprend une électrode (30, 31) intérieure tournée vers le support (10), **caractérisé en ce que** l'électrode (30, 31) intérieure de l'électret (40, 41) piézo-électrique est reliée au support (10) par une couverture (par exemple 20) supplémentaire, conductrice de l'électricité, qui est en contact électrique en un certain nombre de points avec l'électrode (30, 31) intérieure, la couverture (par exemple 20) conductrice ne passant pas du côté du support (10) qui est éloigné de l'électret piézo-électrique et **en ce que** le support (10) est en une matière thermodurcissable.

2. Transducteur piézo-électrique de flexion suivant la revendication 1, **caractérisé en ce que** le contact extérieur de l'électrode (30, 31) intérieur s'effectue par une feuille (60) métallique, de préférence par une feuille en cuivre qui convient pour y ménager un contact (61) de brasure.

3. Transducteur piézo-électrique de flexion suivant la revendication 2, **caractérisé en ce qu'**une partie de la feuille (60) métallique est interposée entre l'électret (40, 41) piézo-électrique et le support (10).

4. Transducteur piézo-électrique de flexion suivant la revendication 2, **caractérisé en ce que** le support (10) est plus long que l'électret (40, 41) piézo-électrique et la couverture conductrice s'étend sur une partie libre du support et y est en contact avec la feuille (60) métallique.

5. Transducteur piézo-électrique de flexion suivant l'une des revendications précédentes, **caractérisé en ce que** la couverture conductrice est une feuille (20) ductile.

6. Transducteur piézo-électrique de flexion suivant l'une des revendications précédentes, **caractérisé en ce que** la couverture conductrice est un réseau (21).

7. Transducteur piézo-électrique de flexion suivant la revendication 6, **caractérisé en ce que** le réseau (21) est constitué sous la forme de barrettes (22) parallèles.

8. Transducteur piézo-électrique de flexion suivant l'une des revendications précédentes, **caractérisé en ce que** la couverture conductrice est en métal.

9. Transducteur piézo-électrique de flexion suivant l'une des revendications précédentes, **caractérisé en ce que** la couverture conductrice est en une matière plastique conductrice de l'électricité.

10. Transducteur piézo-électrique de flexion suivant la revendication 9, **caractérisé en ce que** la matière plastique est un polymère au carbone.

11. Transducteur piézo-électrique de flexion suivant la revendication 9, **caractérisé en ce que** la matière plastique est une résine époxyde renforcée par de la fibre métallique.

12. Transducteur piézo-électrique de flexion suivant l'une des revendications précédentes, **caractérisé en ce que** l'électrode (30, 31) intérieure est une couche de métallisation.

13. Transducteur piézo-électrique de flexion suivant l'une des revendications précédentes, **caractérisé en ce que** l'électret (40, 41) piézo-électrique a une électrode (50, 51) extérieure sur la face éloignée du support.

14. Transducteur piézo-électrique de flexion suivant la revendication 13, **caractérisé en ce que** l'électrode (50, 51) extérieure est recouverte d'une couche ductile conductrice.

15. Transducteur piézo-électrique de flexion suivant l'une des revendications précédentes, **caractérisé en ce que** le support (10) recouvre les zones de bord de la couverture conductrice et de l'électrode (30, 31) intérieure.

16. Transducteur piézo-électrique de flexion suivant l'une des revendications précédentes, **caractérisé en ce que** des parties dégagées de la couverture conductrice et de l'électrode (30, 31) intérieure sont munies d'un vernis isolant du point de vue électrique.

17. Transducteur piézo-électrique de flexion suivant l'une des revendications précédentes, **caractérisé en ce que** le support (10) a la forme d'une plaquette plate et est muni des deux côtés respectivement d'une couverture conductrice et d'un électret (40, 41) piézo-électrique.

18. Transducteur piézo-électrique de flexion suivant l'une des revendications précédentes, **caractérisé en ce que** l'électret (40, 41) électrique est une céramique piézo-électrique.

19. Procédé de fabrication d'un transducteur piézo-électrique de flexion comprenant un support (10) en un matériau isolant du point de vue électrique, **caractérisé en ce qu'**il consiste à déposer une couverture conductrice sur un pré-imprégné d'une matière thermodurcissable servant de support (10) et à relier le pré-imprégné en incluant la couverture conductrice à l'aide d'un traitement thermique à un électret (40, 41) piézo-électrique, un contact électrique de la couverture électrique avec une électrode (30, 31) intérieure de l'électret (40, 41) piézo-électrique se formant en un certain nombre de points.

20. Procédé suivant la revendication 19, **caractérisé en ce qu'**il consiste à déposer sur le support (10) la couverture conductrice sous la forme d'un réseau (21).

21. Procédé suivant la revendication 19, **caractérisé en ce qu'**il consiste à déposer sur le support (10) la couverture conductrice sous la forme d'un pré-imprégné-toile métallique, de préférence sous la forme d'un pré-imprégné-toile de cuivre et à relier le pré-imprégné-toile métallique à l'électret (40, 41) piézo-électrique par un traitement thermique.
